# NEUE EUROPÄISCHE PATENTSCHRIFT

(11) **EP 0 829 559 B2**
(45) Veröffentlichungstag und Bekanntmachung des Hinweises auf die Entscheidung über den Einspruch: **20.12.2006**
(45) Hinweis auf die Patenterteilung: 15.12.1999
(21) Anmeldenummer: 97115806.8
(22) Anmeldetag: 11.09.1997
(51) Int. Cl.: C30B 13/28, C30B 13/10, C30B 15/04, C30B 15/14, C30B 29/06, C30B 33/02

(54) **Verfahren zur Herstellung von Halbleiterscheiben aus Silicium mit geringer Defektdichte**
Method for producing silicon wafers with a low defect-density
Procédé de fabrication d'une plaquette de silicium ayant une faible densité de défauts

(30) Priorität: 12.09.1996 DE 19637182
(43) Veröffentlichungstag der Anmeldung: 18.03.1998
(73) Patentinhaber: Wacker Siltronic Gesellschaft für Halbleitermaterialien Aktiengesellschaft, 84489 Burghausen (DE)
(72) Erfinder: Graef, Dieter, Dr., 84489 Burghausen (DE); von Ammon, Wilfried, Dr., 84489 Burghausen (DE); Wahlich, Reinhold, 84529 Tittmoning (DE); Krottenthaler, Peter, 84489 Burghausen (DE); Lambert, Ulrich, Dr., 84547 Emmerting (DE)
(74) Vertreter: Rimböck, Karl-Heinz

(56) Entgegenhaltungen:
- EP-A- 0 170 788
- EP-A- 0 644 588
- EP-A- 0 716 168
- EP-A- 0 811 707
- DE-A- 3 905 626
- DE-A- 4 442 239
- US-A- 4 981 549
- US-A- 5 264 189
- IWASAKI T ET AL: "Influence of point defect concentration in growing Cz-Si on the formation temperature of the defects affecting gate oxide integrity" 18TH INTERNATIONAL CONFERENCE ON DEFECTS IN SEMICONDUCTORS. ICDS-18, SENDAI, JAPAN, 23-28 JULY 1995, Bd. 196-201, pt.4, ISSN 0255-5476, MATERIALS SCIENCE FORUM, 1995, TRANS TECH PUBLICATIONS, SWITZERLAND, Seiten 1731-1735, XP002045229
- GRAF D ET AL: "Improvement of Czochralski silicon wafers by high-temperature annealing" JOURNAL OF THE ELECTROCHEMICAL SOCIETY, SEPT. 1995, USA, Bd. 142, Nr. 9, ISSN 0013-4651, Seiten 3189-3192, XP002045230
- YANG J S ET AL: "Intrinsic Gettering in Nitrogen-doped Cz-Si", SOLID STATE PHENOMENA, 1991, BD. 19&20, Seiten 65-68.
- GRAF D ET AL: "Comparison of high temperature annealed Czochralski silicon wafers and epitaxial wafers", MATERIALS SCIENCE AND ENGENEERING B Solid-State Materials for Advanced Technology, JAN. 1996, Bd. 36 Nr. 1-3 Seiten 50-54, ISSN 0921-5107.

## Beschreibung

Gegenstand der Erfindung ist ein Verfahren zur Herstellung von Halbleiterscheiben aus Silicium, die eine geringe Dichte von sogenannten as-grown Defekten aufweisen.
Bekannterweise werden Siliciumscheiben (wafer) von Einkristallen abgetrennt und zu Grundmaterial für die Herstellung elektronischer Bauelemente weiterverarbeitet. Die Einkristalle werden üblicherweise nach der Czochralski-Methode (CZ-Methode) oder dem Zonenzieh-Verfahren (FZ-Methode) hergestellt, wobei schmelzflüssiges Material, in der Regel mit Dotierstoff versetztes Silicium, zu einem sich abkühlenden Einkristall erstarrt. Bei der CZ-Methode wird der Einkristall aus einer Schmelze gezogen, mit der ein Quarzglastiegel gefüllt ist. Dabei löst sich vom Tiegelmaterial stammender Sauerstoff in der Schmelze, der zum Teil in den Einkristall eingebaut wird. Bei der FZ-Methode handelt es sich um ein tiegelfreies Ziehverfahren, so daß die Sauerstoff-Konzentration in zonengezogenen Einkristallen (FZ-Kristallen) wesentlich geringer ist, als in tiegelgezogenen Einkristallen (CZ-Kristallen). Es besteht jedoch die Möglichkeit, FZ-Kristalle während ihrer Herstellung mit Sauerstoff zu dotieren, so daß ihre Sauerstoff-Konzentration Werte erreicht, die mit der Sauerstoff-Dotierung von CZ-Kristallen vergleichbar sind. Eine solche modifizierte FZ-Methode ist beispielsweise in der US-5,089,082 beschrieben. Die Dotierung von FZ-Kristallen mit Sauerstoff wird insbesondere vorgenommen, um das Kristallgitter des Einkristalls mechanisch robuster zu machen und um Sauerstoff-Präzipitate zu nutzen, die als sogenannter intrinsischer Getter metallische Verunreinigungen sammeln.

Sowohl CZ-Kristalle, als auch FZ-Kristalle besitzen kein perfektes Kristallgitter. Es weist Fehlordnungen auf, die als as-grown Defekte bezeichnet werden. Nachfolgend wird nur noch unter dem Begriff "Defekte" auf die as-grown Defekte Bezug genommen. Für die Herstellung elektronischer Bauelemente ist es von zentraler Bedeutung, daß eine Halbleiterscheibe eine möglichst geringe Defektdichte, insbesondere im oberflächennahen Bereich, aufweist. Jeder Defekt, der sich in einem oberflächennahen Bereich einer Siliciumscheibe befindet, kann die Funktion eines elektronischen Bauelements stören oder sogar zum Ausfall des Bauelements führen. Normalerweise sind die Defektdichten bei FZ-Scheiben wesentlich geringer, als die Defektdichten, die bei CZ-Scheiben gefunden werden. Bei sauerstoffdotierten FZ-Scheiben mit einer Sauerstoff-Dotierung von mindestens 4*10¹⁷/cm³ erreichen die Defektdichten jedoch Werte, die in der Größenordnung der Defektdichten von CZ-Scheiben liegen. Die Dotierung von Einkristallen mit Sauerstoff, die im Fall der CZ-Kristalle unvermeidbar und im Fall der FZ-Kristalle häufig erwünscht ist, führt also zwangsläufig zu hohen Defektdichten.

Der Zusammenhang zwischen der Defektdichte und der zu erwartenden Qualität der elektronischen Bauelemente legt die Entwicklung von Einkristallen mit niedriger Defektdichte nahe, zumal bekannt ist, daß die Defektdichte in einer Halbleiterscheibe durch eine, als Tempern (annealing) bezeichnete Temperaturbehandlung reduziert werden kann (M.Sano, M.Hourai, S.Sumita and T.Shigematsu, in Proc. Satellite Symp. to ESS-DERC Grenoble/France, B.O.Kolbesen, Editor, p.3, The Electrochemical Society, Pennington, NJ (1993)). Wesentliche Einflußgrößen beim Tempern sind die Temperatur, die Temperzeit, der Ambient und die Temperrampen. Die Defektdichte-Reduktion ist gewöhnlich um so ausgeprägter, je höher die Temperatur und je länger die Temperzeit ist. Nachteilig daran ist, daß durch langes Tempern bei hohen Temperaturen zwangsläufig die Produktionskosten für die Siliciumscheiben steigen.

Im J.Electrochem. Soc., Vol. 142. No.9, (1995), Seiten 3189-3192 ist ein Aufsatz von D.Gräf et al. erschienen, in dem berichtet wird, daß sich die elektrischen Eigenschaften von Czochralski Si-Halbleiterscheiben durch Tempern bei hohen Temperaturen in Wasserstoff-, Argon- und Sauerstoff-Ambienten deutlich verbessern lassen.

Kürzlich wurde eine Forschungsarbeit veröffentlicht (D.Gräf, U.Lambert, M.Brohl, A.Ehlert, R. Wahlich and P.Wagner, Materials Science and Engineering **B36**, 50 (1996)), aus der hervorgeht, daß die Defektgröße bei der Reduzierung von Defektdichten durch Tempern eine Rolle spielt und daß die Geschwindigkeit, mit der ein Einkristall bei seiner Herstellung abkühlt, die Größenverteilung der Defekte beeinflußt. Die Arbeit enthält jedoch keine Hinweise, ob und wie diese Erkenntnis auf vorteilhafte Weise zur Herstellung von Siliciumscheiben verwendet werden kann.
In der JP8-115919 A ist ein Verfahren beschrieben, bei dem ein Einkristall aus Silizium nach der CZ-Methode mit einer Ziehgeschwindigkeit von 1.3 mm/min oder höher gezogen wird, und davon abgetrennte Substrate bei einer Temperatur von 1100°C oder höher für 30 min oder länger in einer reduzierenden oder inerten Atmosphäre wärmebehandelt werden.
Gemäß der JP5-144827 A wird bei Siliziumscheiben, die Sauerstoff und Kohlenstoff enthalten und von einem Einkristall stammen, ein Anstieg von SPD ("Surface Particle and Defect") genannten Defekten beobachtet, wenn der Einkristall mit einer höheren Ziehgeschwindigkeit gezogen wurde. Nach einer Wärmebehandlung der Scheiben bei 1000 °C in einer Inertgasatmosphäre sinkt die Anzahl der Defekte, ebenso wie die Ausfallrate bei Tests der Durchschlagsfestigkeit von Oxidfilmen auf den Scheiben.
JP6-271399 A offenbart ein Verfahren zum Lösen von Stickstoff in einer Siliziumschmelze und zum Ziehen eines mit Stickstoff dotierten Einkristalls aus der Schmelze, und die Lehre, dass mit dem Dotieren mit Stickstoff ein Abfall der Durchschlagsfestigkeit von Oxidfilmen auf Scheiben verhindert werden kann, die von dem Einkristall erhalten werden.
Untersuchungen von J.S.Yang et al., Solid State Phenomena Vol. 19&20 (1991) pp.65-68 haben gezeigt, dass mit Stickstoff dotierte Siliziumscheiben, die einer drei Schritte umfassenden Wärmebehandlung, bestehend aus einer Hochtemperaturbehandlung bei 1150 °C, einer Keimbildungsbehandlung bei 750 °C und einer Keimwachstumsbehandlung bei 1000 °C, in einer Atmosphäre aus Stickstoff unterzogen werden, eine "denuded zone" im Bereich der Oberfläche und einen darunter liegenden, Sauerstoffpräzipitate enthaltenden und daher Verunreinigungen abfangenden ("getternden") Bereich aufweisen.
Die JP7-109195 offenbart ein Verfahren zur Herstellung von Einkristallen, bei dem der Einkristall mit einer vorgeschriebenen Geschwindigkeit gezogen und in mindestens drei unterschiedlichen Temperaturbereichen mit unterschiedlichen Abkühlraten gekühlt wird, um Kristalleigenschaften zu optimieren. Zur Steigerung der Durchschlagsfestigkeit von Oxidfilmen auf Halbleiterscheiben, die von dem Einkristall erhalten werden, wird empfohlen, den Einkristall im Temperaturbereich von 1420 bis 1300 °C graduell zu kühlen, während eine schnelle Abkühlrate im Temperaturbereich von 1100 bis 800 °C eine Verringerung von OSF-Defekten (oxidationsinduzierenten Stapelfehlern) bewirkt. Graduelles Abkühlen im Temperaturbereich von 800 bis 600 °C unterstützt die Bildung von Sauerstoffpräzipitaten nach einer entsprechenden Wärmebehandlung der Halbleiterscheiben.
In der DE-OS 39 05 626 ist ein Verfahren zur Herstellung von Einkristallen aus Silizium beschrieben, bei dem die Abkühlrate im Temperaturbereich von 1050 bis 850 °C kleiner als 140 min, beispielsweise 50 min gewählt wird, wodurch niedrige Dichten an OSF-Defekten erzielt werden.

Die Aufgabe der Erfindung bestand darin, ein optimiertes Verfahren zur Herstellung von Siliciumscheiben bereitzustellen, das Siliciumscheiben mit einer Sauerstoff-Dotierung von mindestens 4*10¹⁷/cm³ und mit niedriger Dichte an Defekten, die als COP-Defekte identifizierbar sind, zugänglich macht.

Gegenstand der Erfindung ist ein Verfahren gemäß einem der unabhängigen Patentansprüche.

Die Erfinder fanden heraus, daß Schritt a) des Verfahrens nach Anspruch 1 dazu führt, daß die Defektdichte im Einkristall deutlich erhöht ist, verglichen mit den Defektdichten, die bei Vergleichskristallen gefunden werden, die man in dem angegebenen Temperaturbereich langsamer abkühlen ließ. Dementsprechend scheinen Halbleilerscheiben, die aus einem derartigen, defektreichen Einkristall hergestellt werden, als Grundmaterial für die Herstellung elektronischer Bauelemente ungeeignet. Die erhöhte Defektdichte ist jedoch mit einer derartigen Verschiebung der Defektgrößen-Verteilung zu kleinen Defekten (Defekten mit geringerer Raumausdehnung) verbunden, daß die Defektreduzierung durch Tempern der Halbleiterscheiben gemäß Schritt c) ungewöhnlich effizient wird. Sie ist so wirkungsvoll, daß die Defektdichte, die nach dem Tempern gefunden wird, niedriger ist, als die Defektdichte von gleichbehandelten Vergleichsscheiben, die aus den oben genannten Vergleichäkristallen hergestellt wurden. Eine Erklärung für diesen Befund findet sich, wenn man annimmt, daß sich beim Tempern vorzugsweise kleine Defekte lösen. Die größeren Defekte verschwinden beim Tempern hingegen nicht. Sie bleiben zurück und ihre Zahl ist ausschlaggebend für die nachweisbare Defektdichte in der getemperten Siliciumscheibe. Im Hinblick auf defektarme Siliciumscheiben bedeutet dies, daß die Bedeutung der Defektdichte im Einkristall um so geringer ist, je höher der Anteil kleiner Defekte in der Defektgrößen-Verteilung ist. Schritt a) des Verfahrens nach Anspruch 1 stellt sicher, daß der Anteil kleiner Defekte möglichst hoch und der Anteil großer Defekte möglichst niedrig ist. Während des Schritts c) des Verfahrens werden die kleinen Defekte weitgehend beseitigt, so daß die getemperten Siliciumscheiben nur noch niedrige Defektdichten aufweisen.

Die Erfinder fanden weiter heraus, daß auch eine Dotierung des Einkristalls mit Stickstoff die Defektgrößen-Verteilung beeinflußt. Bei Einkristallen, die mit Stickstoff dotiert sind und eine Stickstoff-Dotierung von mindestens 1*10¹⁴/cm³ aufweisen, verschiebt sich die Defektgrößen-Verteilung, verglichen mit der Defektgrößen-Verteilung von Vergleichskristallen ohne Stickstoff-Dotierung, ebenfalls auf vorteilhafte Weise zu Gunsten kleinerer Defekte. Siliciumscheiben, die aus einem mit Stickstoff dotierten Einkristall hergestellt werden, weisen deshalb nach einer Behandlung gemäß dem Schritt c) des Verfahrens ebenfalls nur noch niedrige Defektdichten auf.

Die Dotierung des Einkristalls mit Stickstoff kann während der Herstellung des Einkristalls gemäß Schritt a) des Verfahrens nach Anspruch 1 erfolgen. Grundsätzlich genügt es jedoch, einen mit Stickstoff dotierten Einkristall aus Silicium mit einer Sauerstoff-Dotierung von mindestens 4*10¹⁷/cm³ und einer Stickstoff-Dotierung von mindestens 1*10¹⁴/cm³ bereitzustellen und gemäß den Schritten b) und c) des Verfahrens weiterzubehandeln. Die Dotierung des Einkristalls mit Stickstoff kann also als Ersatz für die im Schritt a) des Verfahrens nach Anspruch 1 geforderte rasche Abkühlung des Einkristalls im angegebenen Temperaturbereich von 850 bis 1100 °C erfolgen.

Versuche haben ergeben, daß die Wirkung einer Dotierung des Einkristalls mit Stickstoff in Bezug auf die Defektgrößen-Verteilung auch im Zusammenhang mit der Dotierung des Einkristalls mit Sauerstoff betrachtet werden muß. Bei gleicher Dotierung mit Stickstoff ist der Anteil kleiner Defekte um so höher, je niedriger die Dotierung mit Sauerstoff ist.

Zur Durchführung des Verfahrens wird ein Einkristall unter Anwendung der CZ-Methode oder der FZ-Methode hergestellt. Die Grundzüge beider Herstellungs-Methoden sind beispielsweise in Ullmann's Encyclopedia of Industrial Chemistry, Vol. A23, S.727-731 (1993) beschrieben. Bei Anwendung der FZ-Methode erfolgt die Dotierung mit Sauerstoff vorzugsweise auf die in der US-5,089,082 beschriebenen Weise. Die geforderte, rasche Abkühlung des Einkristalls gemäß dem Schritt a) des Verfahrens ist im Falle der Anwendung der FZ-Methode unkritisch, da ein zonengezogener Einkristall verfahrensbedingt rasch auskühlt und im Temperaturbereich von 850 bis 1100 °C weniger als 80 min bleibt. Bei der Anwendung der CZ-Methode sollte vorzugsweise durch Zwangskühlung sichergestellt werden, daß sich der Einkristall im genannten Temperaturbereich mit der erforderlichen Geschwindigkeit abkühlt. Eine Vorrichtung zur Zwangskühlung des Einkristalls ist beispielsweise in der DE-195 03 357 Al beschrieben.

Die Dotierung eines Silicium-Einkristalls mit Stickstoff erfolgt üblicherweise während der Herstellung des Einkristalls, indem man den Einkristall in einer stickstoffhaltigen Umgebung wachsen läßt, die als Dotierstoff-Quelle dient.

Die Verarbeitung eines Einkristalls zu Siliciumscheiben ist ebenfalls dem Stand der Technik zuzurechnen. Üblicherweise werden Innenloch-oder Drahtsägen verwendet, um Siliciumscheiben vom Einkristall abzutrennen. Zur Bestimmung der Defektdichte und auch der Defektgrößen-Verteilung müssen die Siliciumscheiben präpariert werden. Es sind verschiedene Präparations-Methoden gebräuchlich. Da die Charakterisierung der Defekte wesentlich von der verwendeten Präparations-Methode abhängig ist, sind absolute Angaben zu Defektgrößen nicht möglich. Auswertungen zu Defektgrößen und Defektgrößen-Verteilungen können nur miteinander verglichen werden, wenn sie auf derselben Präparations-Methode beruhen.

Gemäß einer Methode (COP-Test) werden Siliciumscheiben einer Behandlung mit einer sogenannten SC1-Lösung unterworfen, die Defekte als "crystal originated particles" (COP) sichtbar macht. Die Defekte werden dann mit einem kommerziellen Oberflächeninspektions-Gerät nachgewiesen.

Einen quantitativen Schluß auf das Vorhandensein von Defekten läßt auch eine sogenannte GOI-Untersuchung zu (GOI steht für "gate oxide integrity"). Dabei wird die elektrische Durchbruchsfestigkeit einer auf die Oberfläche der Siliciumscheibe aufgebrachten Oxidschicht geprüft. Die Defektcharakterisierung erfolgt bei dieser Methode durch die Angabe einer GOI-Defektdichte. Es ist bereits gezeigt worden, daß die Ergebnisse einer GOI-Untersuchung und die Ergebnisse eines COP-Tests gut miteinander korrelieren (M.Brohl, D. Gräf, P.Wagner, U.Lambert, H.A.Gerber, H.Piontek, ECS Fall Meeting 1994, p.619, The Electrochemical Society, Pennington, NJ (1934)).

Das Verfahren nach Anspruch 1 gemäß Schritt c) umfaßt eine Temperaturbehandlung (Tempem) der Siliciumscheiben bei einer Temperatur von mindestens 1000 °C, vorzugsweise 1100 bis 1200 °C, und einer Temperzeit von mindestens 1 h. Die Siliciumscheiben können einzeln oder in Gruppen getempert werden. Als Ambient wird ein Gas verwendet, das aus einer Gruppe ausgewählt ist, die aus Edelgasen und Wasserstoff besteht. Bevorzugt sind Wasserstoff oder Argon.

Die Erfindung wird nachfolgend an Beispielen vorgestellt.

### Beispiel 1)

Es wurden verschiedene Einkristalle mit einem Durchmesser von 200 mm gemäß der CZ-Methode hergestellt und zu Siliciumscheiben der Kategorie CZ1-CZ3 verarbeitet. In allen Einkristallen lag die Sauerstoff-Konzentration über dem Wert von 5*10¹⁷/cm³. Bei Siliciumscheiben der Kategorie CZ1 war der wachsende Einkristall aktiv gekühlt worden und die Verweilzeit des sich abkühlenden Kristalls im Temperaturbereich von 850 bis 1100 °C lag unter 80 min. Bei den Vergleichsscheiben der Kategorie CZ2 und CZ3 war beim Ziehen des Einkristalls auf eine Zwangskühlung verzichtet worden und die Verweilzeiten im genannten Temperaturintervall lagen über 80 min.
Siliciumscheiben aller drei Kategorien wurden zur Defektcharakterisierung sowohl einer GOI-Untersuchung als auch einem COP-Test unterworfen. Das zur Auswertung des COP-Tests verwendete Oberflächeninspektions-Gerät konnte Defekte nachweisen, die größer als 0,12 µm waren.
Anschließend wurden Siliciumscheiben aller drei Kategorien bei einer Temperaturvon 1200°C und einer Temperzeit von 2h in einem Argon-Ambient getempert und wie zuvor auf Defekte untersucht.

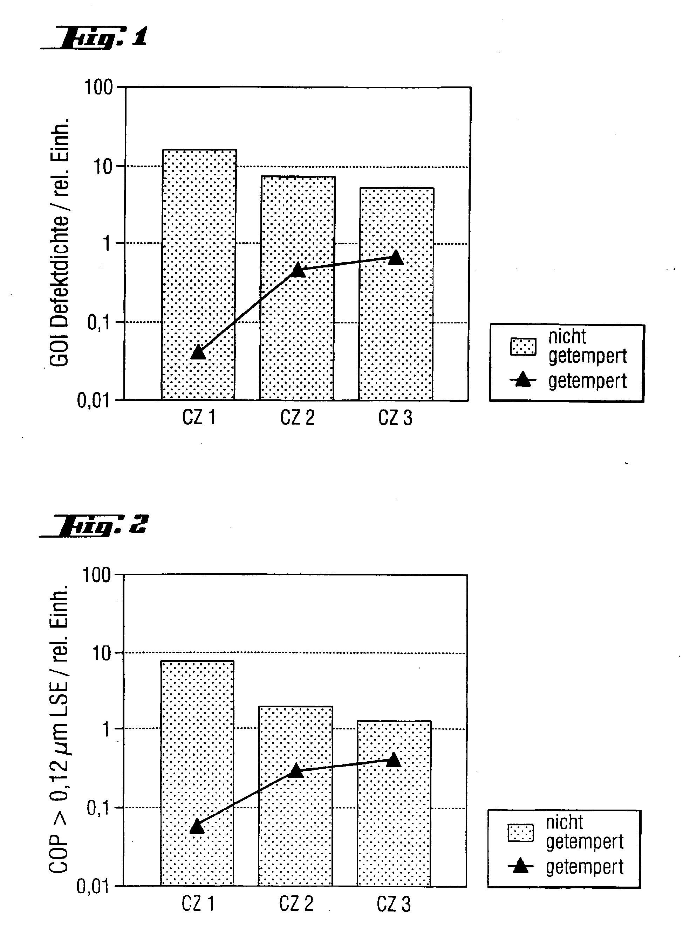

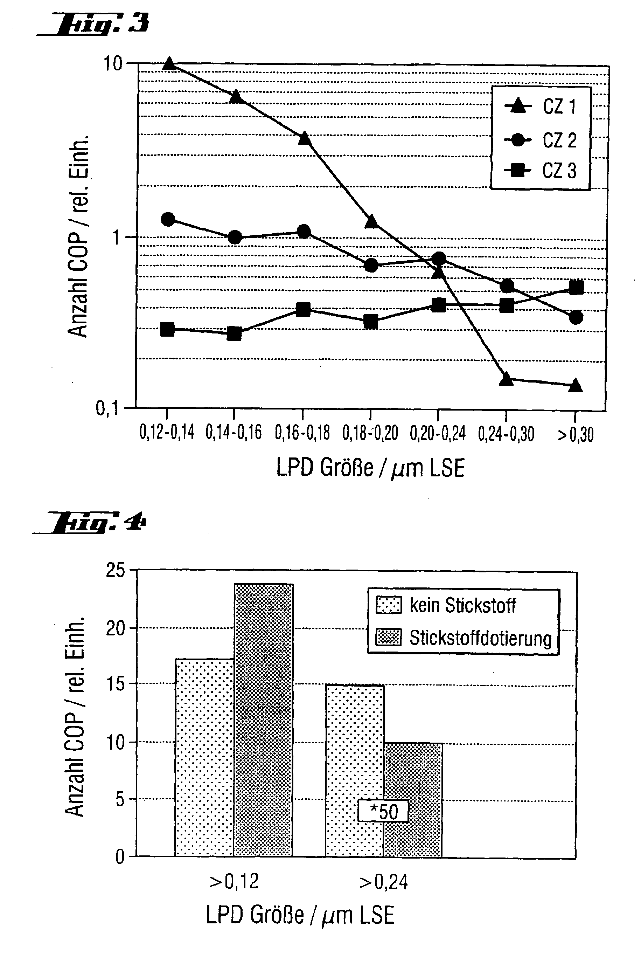

Das Ergebnis der GOI-Untersuchung ist in Figur 1, das Ergebnis des COP-Tests in Figur 2 dargestellt. Vor der Temperaturbehandlung der Siliciumscheiben nahmen die GOl-Defektdichten in der Sequenz CZ3-CZ1 zu. Nach dem Tempern drehte sich dieser Trend um und die GOI-Defektdichten nahmen in der Sequenz CZ1-CZ3 zu. Obwohl die Defektdichten bei allen Siliciumscheiben durch das Tempern abnahmen, war die Defektdichten-Reduzierung bei den Siliciumscheiben der Kategorie CZ1 am ausgeprägtesten.

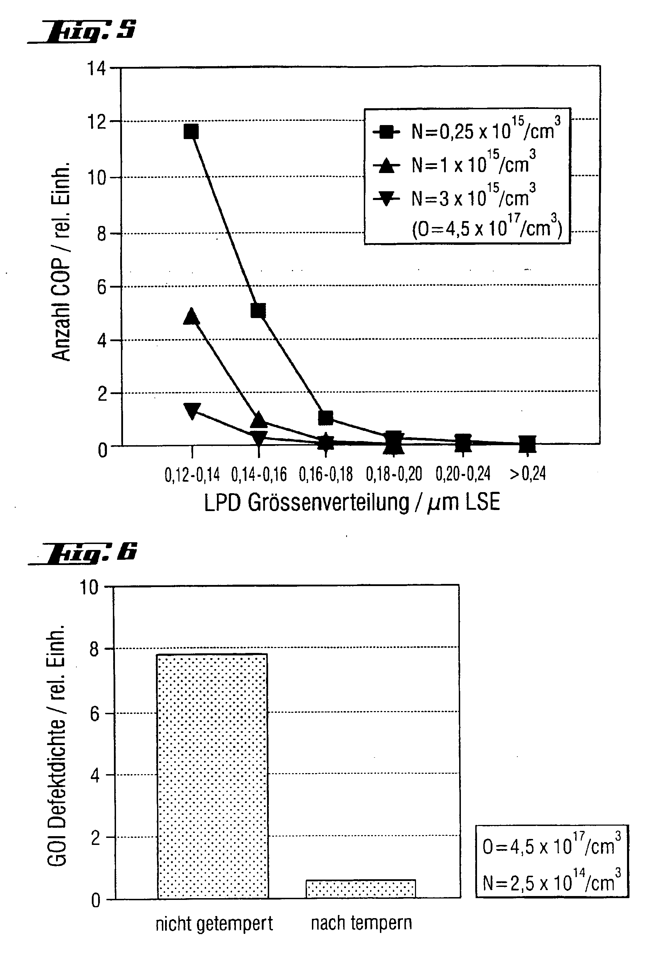

Figur 3 zeigt die Defektgrößenverteilung bei den Siliciumscheiben vor dem Tempern. Während die Defektgrößen bei den Siliciumscheiben der Kategorien CZ2 und CZ3 über den Meßbereich nahezu gleichmä-ßig verteilt sind, ist der Anteil kleiner Defekte bei den Siliciumscheiben der Kategorie CZ1 auffallend hoch und der Anteil großer Defekte auffallend niedrig.

### Beispiel 2)

Es wurden zwei verschiedene Einkristalle mit einem Durchmesser von 200 mm gemäß der CZ-Methode hergestellt und zu Siliciumscheiben verarbeitet. Nur einer der beiden Einkristalle war mit Stickstoff dotiert worden und wies eine Stickstoff-Konzentration von 3*10¹⁴/cm³ auf. In beiden Einkristallen lag die Sauerstoff-Konzentration bei 9*10¹⁷/cm³. Die Analyse der Defektgrößen-Verteilung bei den Siliciumscheiben, deren Ergebnis in Figur 4 dargestellt ist, zeigte, daß durch die Stickstoff-Dotierung eine Verschiebung der Defektgrößen-Vorteilung in Richtung zu kleineren Defekten erreicht wurde.

### Beispiel 3)

Drei Silicium-Kristalle mit einem Durchmesser von 125 mm wurden nach der FZ-Methode hergestellt und zu Siliciumscheiben der Kategorie FZ1-FZ3 verarbeitet. Alle Siliciumscheiben waren mit Sauerstoff dotiert, wobei die Sauerstoff-Konzentration 4,5*10¹⁷/cm³ betrug. Die Dotierung mit Stickstoff war entsprechend der folgenden Aufstellung gewählt worden:

| Kategorie | Dotierstoff-Konzentration |
|---|---|
| FZ1 | 2,5*10¹⁴/cm³ |
| FZ2 | 1,0*10¹⁵/cm³ |
| FZ3 | 3,0*10¹⁵/cm³ |

Siliciumscheiben aller Kategorien wurden zunächst einem COP-Test unterzogen.

Figur 5 zeigt die ermittelte Defektgrößen-Verteilung. Es ist zu erkennen, daß der Anteil großer Defekte mit der Zunahme des Dotierungsgrads stark abnimmt. Die Darstellung der Größenverteilung im Bereich kleiner Defekte ist unvollständig, da Messungen nur bis zur Detektionsgrenze des Oberflächeninspektions-Geräts möglich waren.

Siliciumscheiben der Kategorie FZ1 wurden bei 1200 °C in einem Sauerstoff/Stickstoff Ambient für 3h getempert. Figur 6 zeigt die Ergebnisse einer GOI-Untersuchung, die vor und nach der Temperaturbehandlung an den Siliciumscheiben durchgeführt wurde. Es zeigte sich eine deutliche Verbesserung der GOl-Defektdichten, die auf die Auflösung der kleinen Defekte während der Temperaturbehandlung zurückgeführt werden kann.

## Patentansprüche

1. Verfahren zur Herstellung von Siliciumscheiben mit niedriger Dichte an Defekten, die als COP-Defekte identifizierbar sind, **dadurch gekennzeichnet, dass**
a) ein Einkristall aus Silicium mit einer Sauerstoff-Dotierung von mindestens 4*10¹⁷/cm³ hergestellt wird, indem man schmelzflüssiges Material zu einem Einkristall erstarren und abkühlen lässt, und
die Verweildauer des Einkristalls beim Abkühlen im Temperaturbereich von 850 bis 1100°C kürzer als 80 min ist;
b) der Einkristall zu Siliciumscheiben verarbeitet wird; und
c) die Siliciumscheiben bei einer Temperatur von mindestens 1000 °C für mindestens 1h in einem Ambient getempert werden, wobei als Ambient ein Gas verwendet wird, das aus einer Gruppe ausgewählt ist, die aus Edelgasen und Wasserstoff besteht.

2. Verfahren nach Anspruch 1, **dadurch gekennzeichnet, dass** der Einkristall während des Schritts a) mit Stickstoff dotiert wird und eine Stickstoff-Dotierung von mindestens 1*10¹⁴/cm³ aufweist.

3. Verfahren nach Anspruch 1 oder Anspruch 2, **dadurch gekennzeichnet, dass** der Einkristall beim Abkühlen während des Schritts a) zwangsgekühlt wird.

4. Verfahren zur Herstellung von Siliciumscheiben mit niedriger Dichte an Defekten, die als COP-Defekte identifizierbar sind, **dadurch gekennzeichnet, dass**
a) ein Einkristall aus Silicium mit einer Sauerstoff-Dotierung von mindestens 4*10¹⁷/cm³ und
mit einer Stickstoff-Dotierung von mindestens 1*10¹⁴/cm³ bereitgestellt wird;
b) der Einkristall zu Siliciumscheiben verarbeitet wird; und
c) die Siliciumscheiben bei einer Temperatur von mindestens 1000 °C für mindestens 1h in einem Ambient getempert werden,
wobei Sauerstoff als Ambient ausgenommen ist.

## Claims

1. Process for producing silicon wafers with low density of defects which can be identified as COP defects, **characterized in that**
a) a silicon single crystal having an oxygen doping concentration of at least 4*10¹⁷/cm³ is produced by molten material being solidified to form a single crystal and cooled, and the holding time of the single crystal during cooling in the temperature range of from 850 to 1100°C is less than 80 min;
b) the single crystal is processed to form silicon wafers; and
c) the silicon wafers are annealed at a temperature of at least 1000°C for at least 1h in an atmosphere, a gas being used as atmosphere which is selected from a group consisting of rare gases and hydrogen.

2. Process according to Claim 1, **characterized in that** the single crystal is doped with nitrogen during step a) and has a nitrogen doping concentration of at least 1*10¹⁴/cm³.

3. Process according to Claim 1 or Claim 2, **characterized in that** the single crystal undergoes forced cooling when it cools during step a).

4. Process for producing silicon wafers with low density of defects which can be identified as COP defects, **characterized in that**
a) a silicon single crystal having an oxygen doping concentration of at least 4*10¹⁷/cm³ and a nitrogen doping concentration of at least 1*10¹⁴/cm³ is prepared;
b) the single crystal is processed to form silicon wafers, and
c) the silicon wafers are annealed at a temperature of at least 1000°C for at least 1h in an atmosphere, oxygen being excluded as the atmosphere.

## Revendications

1. Procédé de fabrication de plaquettes de silicium ayant une faible densité de défauts, qui sont identifiables comme défauts COP, **caractérisé en ce que**
a) un monocristal en silicium ayant un dopage en oxygène d'au moins 4*10¹⁷/cm³ est fabriqué, en laissant se solidifier et refroidir un matériau en fusion en un monocristal, et le temps de séjour du monocristal lors du refroidissement dans l'intervalle de température de 850 à 1100°C est inférieur à 80 minutes ;
b) le monocristal est transformé en plaquettes de silicium, et
c) les plaquettes de silicium sont recuites dans un gaz ambiant à une température d'au moins 1000°C pendant au moins 1h, un gaz selectionné dans un groupe constitué de gaz rares et de l'hydrogène étant employé en tat que gaz ambiant.

2. Procédé suivant la revendication 1, **caractérisé en ce que** le monocristal est dopé avec de l'azote pendant l'étape a) et présente un dopage en azote d'au moins 1*10¹⁴/cm³.

3. Procédé suivant la revendication 1 ou la revendication 2, **caractérisé en ce que** le monocristal est refroidi de manière forcée lors du refroidissement pendant l'étape a).

4. Procédé de fabrication de plaquettes de silicium ayant une faible densité de défauts, qui sont identifiables comme défauts COP, **caractérisé en ce que**
a) un monocristal en silicium ayant un dopage en oxygène d'au moins 4*10¹⁷/cm³ et ayant un dopage en azote d'au moins 1*10¹⁴/cm³ est procuré ;
b) le monocristal est transformé en plaquettes de silicium, et
c) les plaquettes de silicium sont recuites dans un gaz ambiant à une température d'au moins 1000°C pendant au moins 1h, l'oxygène comme gaz ambiant étant enlevé.
